# EUROPEAN PATENT SPECIFICATION

(11) **EP 0 336 530 B1**
(45) Date of publication and mention of the grant of the patent: **18.05.1994**
(21) Application number: 89301113.0
(22) Date of filing: 06.02.1989
(51) Int. Cl.: H02K 11/00

(54) **Radio interference suppression**
Funkentstörung
Suppression des parasites radiophoniques

(30) Priority: 07.04.1988 GB 8808146; 24.05.1988 GB 8812283
(43) Date of publication of application: 11.10.1989
(73) Proprietor: AUTOMOTIVE COMPONENTS DUNSTABLE LIMITED, Dunstable Bedfordshire LU6 1UZ (GB)
(72) Inventor: Bates, Trevor, Dunstable Bedfordshire LU6 3NF (GB)
(74) Representative: Britter, Keith Palmer

(56) References cited:
- US-A- 3 924 147
- US-A- 4 329 605
- PHILIPS MATRONICS, no. 11, November 1956, Eindhoven, NL, pp. 189-196 ; H. Krützfeld : "Some Applications of Ferroxcube at Very High Frequencies (VHF)"

## Description

This invention relates to an arrangement for the suppression of radio interference from electric motors, and in particular from electric motors having automotive applications such as in windscreen wiper circuits and heater blower circuits. These electric motors generate electrical noise because of the sparking at the brush/commutator interface. This electrical noise is coupled to the motor vehicle radio receiver by radiation, conduction, or common impedance coupling, causing interference with radio reception.

It is usual practice to include suppression circuit elements with the wiring elements for electric motors which reduce or eliminate interference noise on the radio receiver. These circuit elements usually consist of inductors and capacitors which attenuate the noise voltage, but have little or no effect on the d.c. supply voltage to the electric motor. Because of their construction it is not possible to use only a simple inductor or capacitor to attenuate the noise voltage at all frequencies. For example, a capacitor which can attenuate the noise voltage in the lower radio frequency bands (AM band) of 140 KHz to 1.6 MHz has little or no effect in the higher radio frequency bands (FM band) of 86 MHz to 108 MHz. The capacitor may even cause the noise voltage to increase at frequencies other than those for which it is designed to suppress. This problem occurs because the capacitor can resonate with other circuit elements at certain frequencies causing noise peaks in other radio frequency bands. This interaction between circuit elements is a common problem which limits the use of cost effective components for interference suppression.

Further, it is also the usual practice to use wire wound chokes as the inductors, and to mount these chokes, inside the housing of the electric motor, with the capacitors connected in the wiring circuit which connects the electric motor to the d.c. supply voltage. The use of chokes as inductors, and the positioning of the capacitors does not lend itself to automatic assembly of the suppression circuit elements.

US-A-4,329,605 discloses a PI filter connected to each brush of an electric motor to provide radio interference suppression.

It is an object of the present invention to provide an arrangement for radio interference suppression which has a cost advantage over previously known arrangements, and which lends itself to automatic assembly.

A circuit in accordance with the present invention for the suppression of radio interference from an electric motor having at least two brushes is characterised by the features specified in Claim 1.

Preferably the low frequency interference suppression circuit includes an inductive reactance means which is capable of isolating the capacitor of the low frequency interference suppression circuit at high frequencies.

Where the high and low frequency interference suppression circuits are connected to ground, preferably the ground connections are isolated from one another.

The high and low frequency interference suppression circuits are preferably mounted on a printed circuit board, and a predetermined length of track of the printed circuit board preferably defines the inductive reactance means.

The present invention also comprises an electric motor, preferably for automotive applications, having an arrangement as herein described for radio interference suppression.

The present invention will now be described, by way of example, with reference to the accompanying drawings, in which:-
Figure 1 is a circuit diagram illustrating a typical previously known arrangement;
Figure 2 is a circuit diagram illustrating an arrangement in accordance with a first embodiment of the present invention for suppression of radio interference from an electric motor; and
Figure 3 is an alternative circuit diagram illustrating an arrangement in accordance with a second embodiment of the present invention.

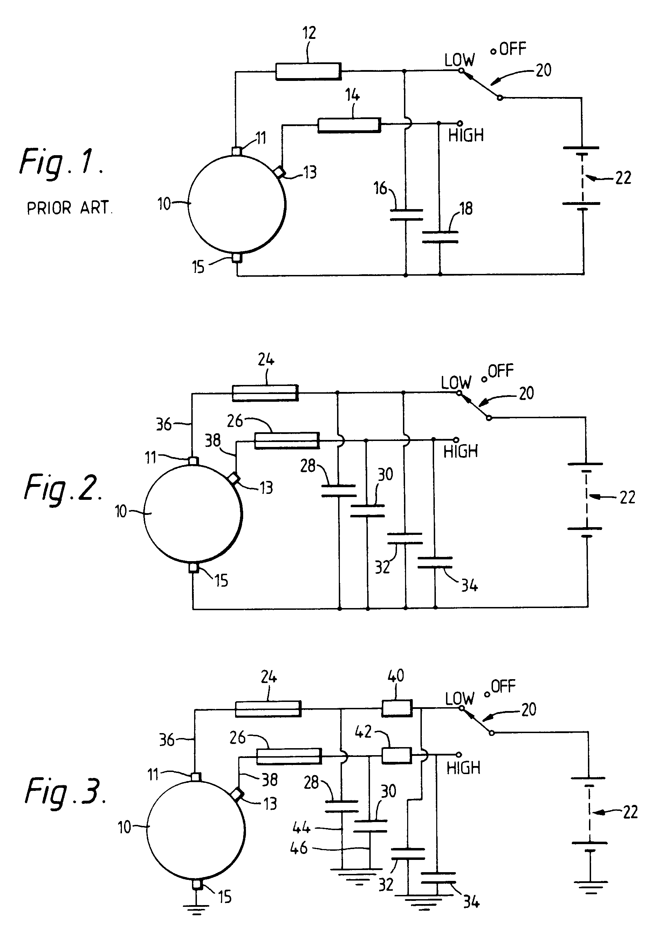

Referring to Figure 1, there is shown a standard electric motor 10 having three brushes 11, 13, 15 for high speed and low speed operation. Brush 15 is a common brush for low speed brush 11 and high speed brush 13. The circuit elements comprise two inductors 12, 14 in the form of wire-wound chokes; two capacitors 16, 18; a switch 20 having three positions, OFF, LOW and HIGH; and a battery 22 for supplying a d.c. supply voltage to the electric motor 10. Inductor 12 and capacitor 16 provide radio interference suppression for the low speed operation of the electric motor 10; and inductor 14 and capacitor 18 provide radio interference suppression for the high speed operation of the electric motor. The inductors 12, 14 give a high impedance path for the higher frequencies, thereby providing radio interference suppression for the FM band. The capacitors 16, 18 give a low impedance path for the lower frequencies, thereby providing radio interference suppression for the AM band.

In the arrangement shown in Figure 2, the electric motor 10, switch 20, and battery 22 are as shown in Figure 1. In this arrangement, however, the wire wound chokes have been replaced by ferrite beads 24, 26 and capacitors 28, 30. The ferrite beads 24, 26 (which surround leads 36, 38) have the effect of increasing the inductance of the leads 36, 38, which are connected to the brushes of the electric motor 10, and so perform as an inductor. However, this in itself is not sufficient to attenuate the noise voltage to an acceptable level, so extra capacitors 28, 30 are required. The frequency response of the ferrite beads 24, 26 is relatively flat, with little or no resonance. The value of the capacitors 28, 30 is therefore chosen such that they self resonate at about 100 MHz (around the mid-point of the FM band) The ferrite beads 24, 26 contribute to this resonance to give a wider bandwidth of attenuation (preferably of at least 35dB) to provide suppression over the whole of the FM band.

Capacitors 32, 34 which are used for radio interference suppression at lower frequencies can, however, (as they are connected in parallel with capacitors 28, 30) have an effect on the resonance on the capacitors 28, 30 causing a loss of attenuation, and a change in the resonant frequency of the capacitors 28, 30. This effect is due to the inductive effect of the capacitors 32, 34 and the leads connected thereto which can reduce the Q and bandwidth, causing a reduction in the attenuating properties of the ferrite beads 24, 26/capacitors 28, 30 circuit.

As a further improvement to the present invention, therefore, the capacitors 32, 34 are effectively isolated from the ferrite beads 24, 26/capacitors 28, 30 circuit as shown in Figure 3. In this arrangement, the ferrite beads 24, 26/capacitors 28, 30 circuit (which define a high frequency interference suppression circuit) are grounded separately from the capacitors 32, 34 (which define a low frequency interference suppression circuit). Further, an additional inductive/high impedance element 40, 42 is included which minimises the effective loading of the capacitors 32, 34 on the ferrite beads 24, 26/capacitors 28, 30 circuit, and thereby effectively isolates the capacitors 32, 34 from the high frequency interference suppression circuit.

By providing separate grounds, common impedance coupling between the capacitors 28, 30 and 32, 34 is reduced.

At high frequencies the additional inductance/high impedance elements 40, 42 are preferably such as to present an inductive reactance of 200 ohms, effectively isolating the capacitors 32, 34 (which typically have an impedance of 20 ohms at high frequency) from the low impedance (approximately 3 ohms) presented by the resonating ferrite beads 24, 26/capacitors 28, 30 circuit. This allows the value of capacitors 28, 30 to be kept low, thereby increasing the attenuation. The length of the leads 44, 46 between the capacitors 28, 30 and ground is preferably kept as short as possible to ensure impedance is kept to a minimum.

In an example of the arrangement in Figure 3, the circuit is assembled on a printed circuit board. Capacitors 32, 34 are 1 microfarad capacitors having a wound or stacked foil construction. Capacitors 28, 30 are 470 pF ceramic plate capacitors. Ferrite beads 24, 26 are 16 mm long and 6 mm in diameter. The additional inductance/high impedance element 40, 42 is provided by a predetermined length of track on the printed circuit board. This arrangement allows automatic assembly of the circuit. When used with, for example, a two speed windscreen wiper motor, the printed circuit board can be mounted within the housing of the motor with the capacitors 32, 34 connected on one side to the ground for the common brush 15 of the motor, and the capacitors 28, 30 connected on one side to the ground provided by the housing of the motor.

Using the present invention, the size of the capacitors 32, 34 for low frequency interference suppression can be reduced over previously known arrangements, hence reducing cost; the use of ferrite beads is considerably cheaper than wire-wound chokes; and the present intention lends itself to automatic assembly.

## Claims

1. A circuit for the suppression of radio interference from an electric motor (10) having at least two brushes (11,13,15), the circuit comprising a high frequency interference suppression circuit connectable across the brushes, and a low frequency interference suppression circuit, the low frequency interference suppression circuit comprising a capacitor (32,34); characterised in that the high frequency interference suppression circuit comprises a ferrite bead (24,26) which surrounds a portion of a lead (36,38) connectable at one end to one of the brushes (11,13) and connected at the other end to a first side of a capacitor (28,30) which is capable of self resonance in the high frequency band, the said other end of the lead also being connected to a first side of the capacitor (32,34) of the low frequency interference suppression circuit, the second sides of the capacitors (28,30,32,34) being connected to another of the brushes (15).

2. A circuit as claimed in Claim 1, wherein the low frequency interference suppression circuit further comprises an inductive reactance means (40,42) in series with the capacitor (32,34) thereof which is effective to isolate the capacitor (32,34) of the low frequency interference suppression circuit from the capacitor (28,30) of the high frequency interference suppression circuit at high frequencies.

3. A circuit as claimed in Claim 1 or Claim 2, wherein the high and low frequency interference suppression circuits are connected to ground, and the ground connections are separated from one another.

4. A circuit as claimed in any one of Claims 1 or 3, wherein the high and low frequency interference suppression circuits are mounted on a printed circuit board.

5. A circuit as claimed in Claim 4 including an inductive reactance means in the low frequency interference suppression circuit, wherein the inductive reactance means comprises a predetermined length of track on the printed circuit board.

6. An electric motor having a circuit as claimed in any one of Claims 1 to 5 connected thereto for providing radio interference suppression.

7. An electric motor as claimed in Claim 6 for use in automotive applications.

## Patentansprüche

1. Schaltkreis zur Funkentstörung eines elektrischen Motors (10) mit zumindest zwei Bürsten (11, 13, 15), wobei der Schaltkreis einen Hochfrequenz-Entstörungsschaltkreis, der über den Bürsten anschließbar ist, und einen Niederfrequenz-Entstörungsschaltkreis umfaßt, wobei der Niederfrequenz-Entstörungsschaltkreis einen Kondensator (32, 34) umfaßt; dadurch gekennzeichnet, daß der Hochfrequenz-Entstörungsschaltkreis eine Ferritperle (24, 26) umfaßt, die einen Teil einer Leitung umgibt, die an einem Ende an eine der Bürsten (11, 13) anschließbar ist und am anderen Ende an eine erste Seite eines Kondensators (28, 30) angeschlossen ist, der in dem Hochfrequenzband eigenresonanzfähig ist, wobei das andere Ende der Leitung ebenfalls an eine erste Seite des Kondensators (32, 34) des Niederfrequenz-Entstörungsschaltkreises angeschlossen ist, wobei die zweiten Seiten der Kondensatoren (28, 30, 32, 34) an eine andere der Bürsten (15) angeschlossen sind.

2. Schaltkreis nach Anspruch 1, in dem der Niederfrequenz-Entstörungsschaltkreis weiter ein induktives Reaktanzmittel (40, 42) in Serie zu dem Kondensator (32, 34) umfaßt, das wirksam ist, den Kondensator (32, 34) des Niederfrequenz-Entstörungsschaltkreises von dem Kondensator (28, 30) des Hochfrequenz-Entstörungsschaltkreises bei hohen Frequenzen zu isolieren.

3. Schaltkreis nach Anspruch 1 oder Anspruch 2, in dem die Hoch- und Niederfrequenz-Entstörungsschaltkreise mit der Erde verbunden sind und die Erdverbindungen voneinander getrennt sind.

4. Schaltkreis nach einem der vorhergehenden Ansprüche, in dem die Hoch- und Niederfrequenz-Entstörungsschaltkreise auf einer Leiterplatte aufgebaut sind.

5. Schaltkreis nach Anspruch 4 mit einem induktiven Reaktanzmittel in dem Niederfrequenz-Entstörungsschaltkreis, wobei das induktive Reaktanzmittel eine vorbestimmte Länge einer Leiterbahn auf der Leiterplatte umfaßt.

6. Elektrischer Motor mit einem angeschlossenen Schaltkreis nach einem der vorhergehenden Ansprüche um eine Funkentstörung herbeizuführen.

7. Elektrischer Motor nach Anspruch 6 zur Verwendung in kraftfahrtechnischen Anwendungen.

## Revendications

1. Circuit pour la suppression des parasites radioélectriques en provenance d'un moteur électrique (10) ayant au moins deux balais (11, 13, 15), le circuit comprenant un circuit de suppression des interférences haute fréquence pouvant être connecté aux bornes des balais, et un circuit de suppression des interférences basse fréquence, le circuit de suppression des interférences basse fréquence comprenant un condensateur (32, 34); caractérisé en ce que le circuit de suppression des interférences haute fréquence comporte un barreau de ferrite (24, 26) qui entoure une partie d'un conducteur (36, 38) pouvant être connecté à une extrémité à l'un des balais (11, 13) et connecté à l'autre extrémité à un premier côté d'un condensateur (28, 30) qui peut entrer en autorésonance dans la bande des hautes fréquences, ladite autre extrémité du conducteur étant aussi connectée à un premier côté du condensateur (32, 34) du circuit de suppression des interférences basse fréquence, les seconds côtés des condensateurs (28, 30, 32, 34) étant connectés à un autre des balais (15).

2. Circuit selon la revendication 1, dans lequel le circuit de suppression des interférences basse fréquence comporte en outre des moyens (40, 42) formant réactance inductive en série avec le condensateur (32, 34) de celui-ci qui est efficace pour isoler le condensateur (32, 34) du circuit de suppression des interférences basse fréquence du condensateur (28, 30) du circuit de suppression des interférences haute fréquence aux fréquences élevées.

3. Circuit selon la revendication 1 ou la revendication 2, dans lequel les circuits de suppression des interférences haute et basse fréquence sont connectés à la masse, et les connexions à la masse sont séparées les unes des autres.

4. Circuit selon l'une quelconque des revendications 1 ou 3, dans lequel les circuits de suppression des interférences haute et basse fréquence sont montés sur une carte à circuit imprimé.

5. Circuit selon la revendication 4 comprenant un moyen formant réactance inductive dans le circuit de suppression des interférences basse fréquence, dans lequel le moyen formant réactance inductive comporte une longueur prédéterminée de trajet sur la carte à circuit imprimé.

6. Moteur électrique ayant un circuit tel que revendiqué dans l'une quelconque des revendications 1 à 5 qui lui est relié pour permettre la suppression des interférences radioélectriques.

7. Moteur électrique tel que revendiqué dans la revendication 6 destiné à être utilisé dans des applications de l'automobile.
